(19) Europäisches Patentamt

European Patent Office

Office européen des brevets

(11) Numéro de publication : **0 146 093**
**B1**

(12) **FASCICULE DE BREVET EUROPÉEN**

(45) Date de publication du fascicule du brevet :
30.09.87

(21) Numéro de dépôt : **84114954.5**

(22) Date de dépôt : **08.12.84**

(51) Int. Cl.⁴ : **G 01 R 31/36**

(54) **Procédé de mesure de l'état de décharge d'une pile et appareil mettant en oeuvre ce procédé.**

(30) Priorité : **12.12.83 FR 8319979**

(43) Date de publication de la demande :
**26.06.85 Bulletin 85/26**

(45) Mention de la délivrance du brevet :
**30.09.87 Bulletin 87/40**

(84) Etats contractants désignés :
**CH DE GB LI**

(56) Documents cités :
**US-A- 3 984 762**
**US-A- 3 997 834**
**JOURNAL OF APPLIED ELECTROCHEMISTRY, vol. 10, no. 3, mai 1980, pages 357-363, Londres, GB; S.A.G.R. KARUNATHILAKA et al.: "The impedance of the Leclanche cell. I. The treatment of experimental Data and the behavior of a tpical undischarged cell" JOURNAL OF APPLIED ELECTROCHEMISTRY, vol. 13, no. 5, septembre 1983, pages 577-586, Chapman and Hall Ltd., Londres, GB; S.A.G.R. KARUNATHI-LAKA et al.: "The prediction of the state-of-charge of some commercial primary cells"**

(73) Titulaire : **ASULAB S.A.**
**Faubourg du Lac 6**
**CH-2502 Bienne (CH)**

(72) Inventeur : **Randin, Jean-Paul**
**Potat-Dessus 13**
**CH-2016 Cortaillod (CH)**
Inventeur : **Zuellig, Frédy**
**Saint-Germain 2**
**CH-2800 Delemont (CH)**
Inventeur : **Leuenberger, Claude-Eric**
**Grand Chézard**
**CH-2054 Chezard (CH)**

(74) Mandataire : **Gresset, Jean**
**ICB Ingénieurs Conseils en Brevets SA Faubourg du Lac 6**
**CH-2501 Bienne (CH)**

## Description

La présente invention concerne un procédé de mesure ou de test non destructif permettant de déterminer l'état de décharge d'une pile. Elle concerne également un appareil ou instrument mettant en œuvre ce procédé de mesure.

Une pile est caractérisée électriquement par la tension électrique à circuit ouvert existant entre ses bornes, par sa résistance interne et par sa capacité. Cette dernière, exprimée en général en ampères-heures (Ah) ou en milliampères-heures (mAh), indique quel courant la pile peut fournir pendant un laps de temps donné, avant que sa tension sous une charge appropriée ne descende en dessous d'une valeur prédéterminée.

Pour une pile usagée, le rapport entre les Ah qu'elle a fourni sur une charge et sa capacité nominale définit l'état de décharge de la pile, grandeur désignée par D et exprimée en général en %.

Alors que la tension à circuit ouvert d'une pile d'un type donné est un paramètre bien connu et stable, sa capacité peut présenter une certaine dispersion par rapport à la valeur nominale. L'état de décharge d'une pile dépend, de son côté, de la façon dont elle a été utilisée ou même stockée, donc de son histoire. En effet même à l'état de stockage à température ambiante une pile a tendance à se décharger, ce qui fait que son état de décharge est impossible à connaître avec précision, sinon par une mesure.

Les procédés connus de détermination de l'état de décharge D d'une pile sont malheureusement difficiles à mettre en œuvre et peu précis. Ils reposent essentiellement soit sur la mesure de la résistance R ou de l'impédance complexe Z de la pile, soit sur la mesure de sa tension E sous charge, c'est-à-dire lorsque la pile débite un courant i. Ce sont en effet les seuls paramètres qui varient de façon significative en fonction de l'état de décharge de la pile.

Par exemple un procédé de mesure de D consiste à soumettre la pile à une rampe de courant augmentant avec le temps de façon constante. La tension que la pile atteint après un certain temps ou pour un courant donné, ou encore la valeur de sa résistance en courant continu, donnée par la tangente à la courbe E = f(i), peuvent être prises comme valeurs représentatives de l'état de décharge de la pile, ainsi que cela est montré dans l'article de J. J. Winter et al., Journal of Electrochem. Soc. 122 (1975) p. 1434-1438 ou dans le brevet US 4,204,162 Froidevaux, mai 1980. Ce procédé, compliqué à mettre en oeuvre, s'est révélé être peu précis.

Un procédé galvanostatique a été proposé par F. Kornfeil dans l'article « Some observations on the prediction of the state of discharge of batteries », Journal of Electrochem. Soc. 123 (1976) p. 1271-1276. Il consiste à faire débiter par la pile un courant constant et à prendre comme grandeur représentative de son état de décharge D la tension qu'elle présente au bout d'un temps prédéterminé. Les résultats obtenus par ce procédé de mesure présentent une précision satisfaisante. Cependant la résistance de la pile, laquelle dépend de son état de décharge et varie d'un échantillon à un autre, provoque une chute de tension au moment de l'enclenchement du courant constant et introduit dans les mesures une dispersion indésirable. Une méthode de mesure améliorée a été proposée par la demanderesse dans la demande de brevet française no 8304430 dans laquelle la résistance de la pile n'intervient plus dans la détermination de son état de décharge. Cette méthode donne généralement de bons résultats mais dans certains cas elle manque de précision dans la mesure des faibles valeurs de D.

Enfin des procédés de mesure de D basés sur l'utilisation de certains paramètres de l'impédance complexe interne Z de la pile ont été décrits dans de nombreuses publications.

Par exemple dans l'article intitulé « Impedance parameters and the state-of-charge. I. Nickel-cadmium battery » par S. Sathyanarayana et al. paru dans la revue Journal of Applied Electrochemistry 9 (1979) p. 125-139 les auteurs montrent que l'argument a de l'impédance complexe Z, mesurée à une fréquence adéquate, a étant aussi l'angle de déphasage entre la tension aux bornes de l'impédance Z et le courant qui la traverse, est un paramètre dont la valeur est étroitement liée à l'état de décharge D de la pile. Dans ce procédé cependant, la résistance ohmique interne de la pile, qui dépend de son état de décharge et qui peut varier d'un échantillon à un autre, diminue la précision des mesures.

L'extrémité du vecteur Z, représentant l'impédance interne de la pile, décrit dans le plan complexe sensiblement un arc de cercle lorsque la fréquence de mesure f varie approximativement de 10 Hz à 10 kHz. Le diamètre d du cercle correspondant peut aussi être pris comme paramètre représentatif de D, ainsi que cela a été montré dans l'article « The impedance of the alkaline zinc-mercuric oxide cell. I. Cell behaviour and interpretation of impedance spectra », S. A. G. R. Karunathilaka et al., Journal of Applied Electrochemistry 11 (1981) p. 573-582. Ce procédé, même s'il donne des résultats précis, a l'inconvénient de nécessiter un grand nombre de points de mesure pour déterminer D.

L'argument a passe par un minimum à une fréquence f min lorsque l'impédance Z est mesurée dans une bande de fréquence allant de 0.01 Hz à 10 kHz, comme cela a été montré dans l'article « A state-of-charge test for the Li-CuO cell », S. A. G. R. Karunathilaka et al., Journal of Applied Electrochemistry, 13 (1983) p. 351-354. Cette fréquence f min, variant avec l'état de décharge de la pile, peut aussi être prise comme paramètre de mesure de D. La détermination de f min demande cependant un nombre élevé de points de mesure.

Comme dernier exemple on peut citer le procédé consistant à prendre la partie réelle R de l'impédance Z, mesurée à une fréquence donnée, comme paramètre représentatif de D. Ce procédé a été décrit dans l'article « The prediction of the state-of-charge of some commercial primary cells », S. A. G. R. Karunathilaka et al., Journal of Applied Electrochemistry 13 (1983) p. 577-586. L'inconvénient principal de cette méthode consiste en la difficulté de trouver une fréquence où la corrélation entre R et l'état de décharge est satisfaisante. De plus, la résistance ohmique de la pile influence et diminue la précision des mesures.

L'objet principal de l'invention est de fournir un procédé de mesure, basé sur la détermination de l'argument d'une impédance, ne présentant pas ces inconvénients.

Pour atteindre cet objectif, le procédé de mesure de l'état de décharge d'une pile selon l'invention est principalement remarquable en ce qu'il consiste :

à mesurer une première impédance interne de la pile à une première fréquence ;

à mesurer une seconde impédance interne de la pile à une seconde fréquence ;

à déterminer la différence entre les deux impédances internes mesurées ; enfin à déterminer l'argument de cette différence d'impédances, lequel argument est représentatif de l'état de décharge de la pile.

Un avantage du procédé de mesure selon l'invention est que la chute de tension due à la résistance ohmique interne de la pile ne vient plus fausser la détermination de la capacité restante de la pile. Un autre avantage de ce procédé est qu'il ne nécessite pas un nombre élevé de points de mesure.

L'invention a encore pour objet de fournir un appareil de mesure permettant de déterminer de façon rapide, précise et non destructive l'état de décharge d'une pile sans diminuer de façon significative sa capacité, en mettant en oeuvre le procédé de mesure selon l'invention.

Le dessin annexé illustre un procédé de mesure connu et, à titre d'exemple nullement limitatif, un procédé selon l'invention ainsi qu'un appareil de mesure mettant en œuvre ce procédé ; sur ce dessin :

La figure 1 représente un schéma de principe permettant de mesurer l'impédance complexe interne d'une pile ;

La figure 2 montre la courbe décrite dans le plan complexe par l'extrémité du vecteur représentant l'impédance interne d'une pile, la fréquence de mesure étant prise comme paramètre variable ;

la figure 2a montre l'influence de la résistance ohmique interne d'une pile sur la courbe C de la fig. 2 ;

La figure 3 donne un exemple de courbe obtenue par le procédé selon l'invention reliant l'état de décharge d'une pile à l'argument de l'impédance complexe obtenue en soustrayant d'une première impédance interne de la pile, mesurée à une première fréquence, une seconde impédance interne, mesurée à une seconde fréquence ; enfin

la figure 4 représente le schéma d'un exemple d'appareil de mesure de l'état de décharge d'une pile mettant en œuvre le procédé selon l'invention.

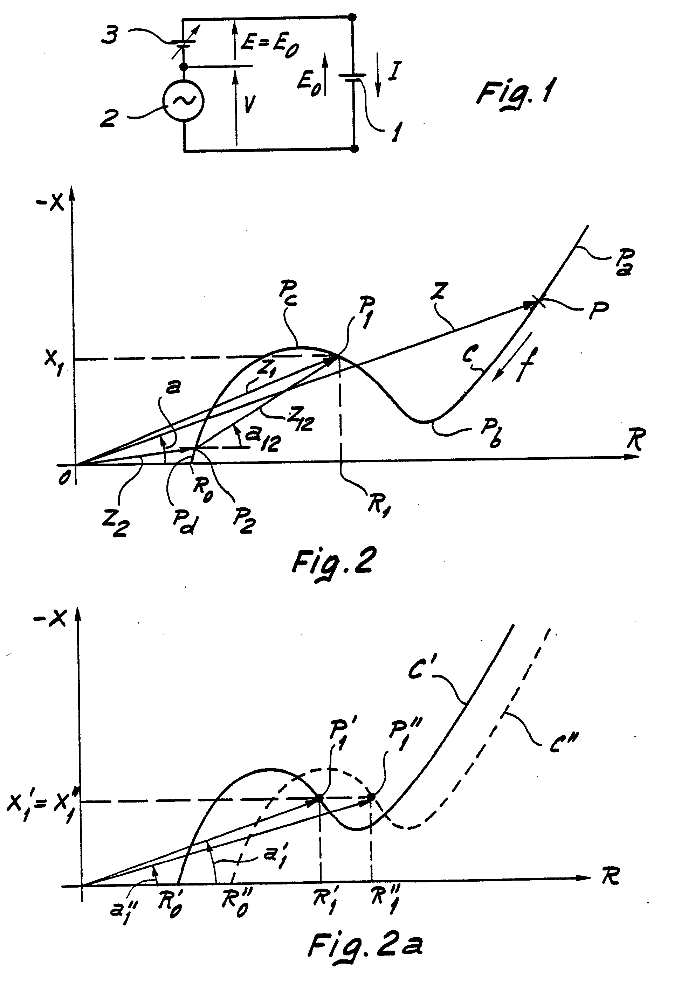

Le principe de mesure selon l'invention étant basé sur la détermination de l'argument d'une impédance complexe déduite de l'impédance complexe interne d'une pile, la définition et la méthode de mesure de cette dernière grandeur seront d'abord données à l'aide du schéma de la fig. 1. Ce schéma comprend une pile à mesurer 1, un générateur de tension alternative 2 de fréquence variable f et un générateur variable de tension continue 3. La pile et les deux générateurs sont reliés en série dans un ordre quelconque mais de façon que la pile et le générateur de tension continue aient en commun des pôles de même signe, les pôles positifs dans le cas présent. Les impédances internes des générateurs sont supposées être négligeables par rapport à celles de la pile. La tension à vide de la pile 1 est désignée par Eo, la tension efficace du générateur 2 par V et la tension continue du générateur 3 par E. La tension E est choisie égale à Eo pour éviter que la pile 1 ne débite un courant continu. De cette façon le courant circulant dans la boucle formée par la pile et les deux générateurs n'a pas de composante continue et sa composante alternative I est uniquement déterminée par la tension V.

Le blocage de la composante continue pourrait aussi être obtenu en remplaçant le générateur 3 par un condensateur, mais sa capacité deviendrait rapidement prohibitive aux très basses fréquences.

Les grandeurs V et I sont des nombres complexes et leur rapport $V/I = Z = R + jX$ définit l'impédance complexe interne de la pile 1. Cette impédance Z a une partie réelle, ou résistive, R, et une partie imaginaire, ou réactive, X, dont le rapport $X/R = tg\ a$ définit l'argument a de l'impédance.

Cet argument a a pour valeur arc tg $X/R$ qui est égale au retard de phase, ou déphasage, du courant I sur la tension V.

En portant, dans un plan complexe, la résistance R sur l'axe réel et la réactance X sur l'axe imaginaire, ces deux axes ayant une origine commune O, à chaque fréquence f correspond un point P de ce plan, comme cela est montré sur la fig. 2. Le vecteur OP est l'image de l'impédance Z et l'angle qu'il fait avec l'axe réel est égal à l'argument a. Lorsque la fréquence de mesure f varie en augmentant, le point P décrit une courbe C dans le sens des points Pa, Pb, Pc, Pd. Cette courbe C se compose d'un segment Pa, Pb approximativement rectiligne suivi d'une partie Pb, Pc, Pd, ayant sensiblement la forme d'un arc de cercle. Pour certaines piles la partie haute fréquence de la courbe C a plutôt l'allure d'une droite de pente inférieure à celle de la partie basse fréquence Pa Pb. Cette différence de forme

de la réponse à basse fréquence n'influence pas l'efficacité de la méthode proposée. La partie réactive X de l'impédance Z est capacitive et a ainsi une valeur négative. Typiquement la tension de mesure V est comprise entre 1 et 10 mV et la fréquence de mesure f entre 0,01 et 1 Hz pour le segment Pa, Pb et entre 1Hz et 10 kHz pour l'arc de cercle Pb, Pc, Pd. Ces valeurs de fréquence sont typiques d'une pile neuve ; elles varient avec l'état de décharge. Pour des fréquences de l'ordre de 10 kHz ou plus, la partie réactive X est pratiquement nulle et l'impédance Z se réduit à la résistance ohmique interne Ro de la pile.

Dans le procédé de mesure connu où l'argument de l'impédance interne de la pile est pris comme paramètre représentatif de son état de décharge, la fréquence de mesure est choisie généralement de façon que le point P correspondant soit situé entre les points Pb et Pc, sur la partie circulaire de la courbe C. En désignant par f1 cette fréquence, il lui correspond l'impédance Z1, la résistance R1, la réactance X1 et le point P1 sur la courbe C, comme on le voit sur la fig. 2.

Considérons maintenant deux piles de même type, se trouvant dans le même état de décharge et ayant des résistances internes R'o et R"o différentes. Dans le plan complexe, les courbes C', C" représentatives de l'impédance de ces piles sont semblables, mais décalées l'une par rapport à l'autre le long de l'axe réel comme cela est montré sur la fig. 2a. Il est alors évident qu'à la fréquence de mesure f1, aux points P'1, P"1, les réactances X'1, X"1 des deux piles seront identiques tandis qu'une différence apparaîtra entre les deux résistances R'1 et R"1. Cette différence sera égale à celle des résistances ohmiques internes R'o et R"o des deux piles. Comme l'argument a1 vaut arc tg X1/R1, on voit qu'on obtiendra deux valeurs différentes a'1, a"1 pour ce paramètre par suite de l'écart existant entre les deux valeurs de R1, donc de Ro. Cette mesure donnera ainsi des états de décharge D différents alors que l'égalité des capacités restantes était admise au départ pour les deux piles.

La présente invention, qui sera maintenant décrite, a pour objet d'éliminer l'influence de Ro dans la mesure de D en choisissant comme paramètre représentatif de l'état de décharge d'une pile une grandeur qui reste invariante par rapport à toute translation de la courbe C dans le plan complexe.

Pour atteindre ce but, le procédé de mesure selon l'invention consiste à déterminer une première valeur Z1 et une seconde valeur Z2 de l'impédance interne de la pile, respectivement à des fréquences f1 et f2, et à prendre comme paramètre représentatif de son état de décharge D l'argument a12 de la différence Z12 = Z1-Z2, ainsi que cela est montré sur la fig. 2. En désignant par R1, R2 et X1, X2 respectivement les parties réelles et imaginaires de Z1 et Z2, il vient pour l'argument a12 = arc tg (X1-X2)/(R1-R2). Comme R1-R2 est indépendant de Ro, il en est de même de a12, ce qui représente un premier avantage. Un second avantage de ce procédé est qu'il ne demande que deux mesures d'impédance.

La fréquence f2 est avantageusement choisie de façon que la partie réactive X2 de cette impédance interne soit sensiblement nulle à cette fréquence. Typiquement cette fréquence est comprise entre 3 et 10 kHz. Dans ces conditions la résistance R2 devient approximativement égale à Ro. L'expression donnant l'argument a12 s'écrit alors a12 = arc tg X1/(R1Ro). La fréquence f1 peut être choisie en mesurant les valeurs a12 pour une série de fréquences comprises entre 0,01 Hz et 10 kHz et en reportant a12 = fonction (log f1) pour plusieurs états de décharge compris entre 0 et 100 % D. L'examen de la famille de courbes a12 = fonction (log f1) permet de choisir la fréquence f1 la mieux appropriée à une sélection effectuée à un état de décharge donné. Typiquement la fréquence f1 est comprise entre 0,1 et 10 Hz.

L'argument a21 de l'impédance Z2-Z1 aurait pu, tout aussi bien, être pris comme paramètre représentatif de D à la place de l'argument a12 de l'impédance Z1-Z2. En effet, comme les vecteurs correspondant aux impédances Z2-Z1 et Z1-Z2 ont des directions opposées, il en résulte que a21 = a12 + 180°. Les deux arguments ne différant que par une constante, ils sont aussi représentatifs l'un que l'autre de D.

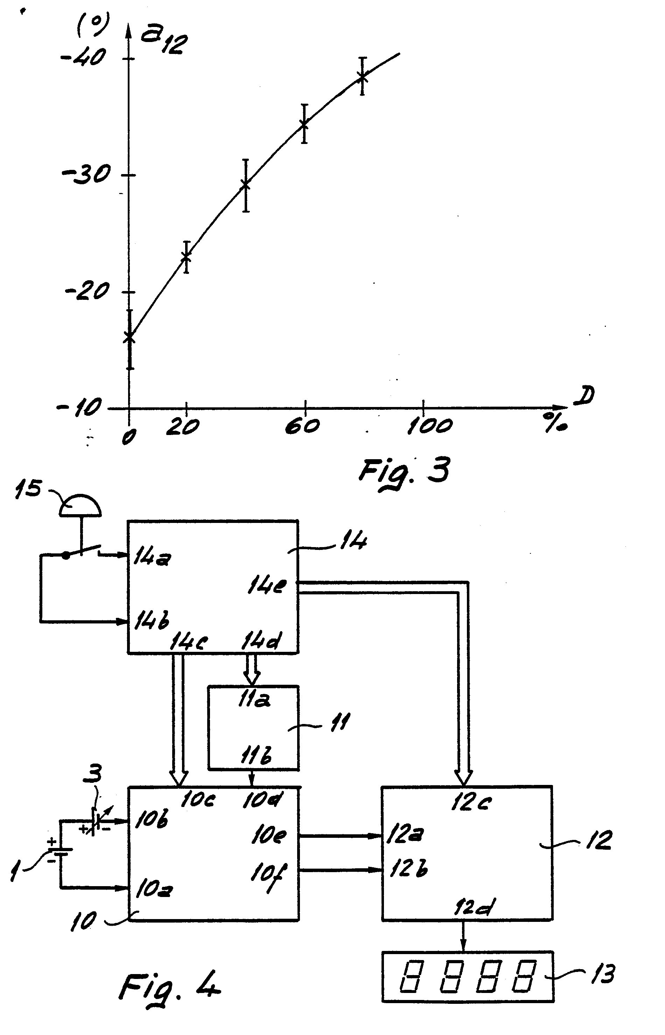

Un exemple de relation existant entre l'argument a12, mesuré en degrés, et l'état de décharge D d'une pile, exprimé en %, est représenté sur la fig. 3. Un lot de 5 piles $Ag_2O$-Zn de 30 mAh de capacité nominale a été utilisé pour les mesures à chaque état de décharge. Les mesures ont été faites avec une tension alternative V de 2mV aux fréquences f1 et f2 respectivement de 4 Hz et de 10 kHz. La courbe joint les points représentant les valeurs moyennes de a12. Les segments associés à ces points indiquent les valeurs extrêmes obtenues. On peut constater que a12 varie rapidement avec D et que la dispersion des points de mesure est faible.

L'argument a12 varie généralement entre — 10 et — 50°. Un argument plus petit que typiquement — 25° correspond à un état de décharge plus petit que 30 % D.

Un appareil électronique, mettant en œuvre le procédé de mesure selon l'invention, qui permet de déterminer de façon simple, rapide, précise et non destructive l'état de décharge d'une pile, sera maintenant décrit en se référant à la figure 4.

Cet appareil comprend la pile à mesurer 1, le générateur variable de tension continue 3, un pont de mesure 10, un oscillateur 11 pouvant fournir les fréquences f1 et f2, une unité de calcul 12, un affichage 13, par exemple numérique, pour indiquer les résultats, une unité de commande 14 et enfin un contact actionné par un bouton 15.

Le pont de mesure 10 a deux entrées 10a et 10b destinées à être connectées à l'impédance à mesurer, une entrée de commande 10c, une entrée 10d à laquelle est appliquée la fréquence de mesure et deux sorties 10e et 10f fournissant respectivement les valeurs des parties résistive et réactive de l'impédance à mesurer. L'oscillateur 11 a une entrée de commande 11a et une sortie 10b sur laquelle apparaît un signal ayant la fréquence de mesure f1 ou f2. L'unité de calcul 12 a deux entrées 12a et 12b destinées à recevoir respectivement les valeurs des parties résistive et réactive de l'impédance à mesurer, une entrée de commande 12c et une sortie 12d sur laquelle apparaît le résultat du calcul effectué par cette unité sur les grandeurs introduites sur les entrées 12a et 12b. L'affichage 13 a une seule entrée, laquelle reçoit la grandeur à indiquer. Enfin l'unité de commande 14 a deux entrées 14a et 14b et trois sorties de commande 14c, 14d et 14e.

La borne négative de la pile 1 est reliée à l'entrée 10a du pont 10. La borne positive de cette pile est connectée à la borne positive du générateur de tension continue 3 dont la borne négative est reliée à l'entrée 10b du pont 10. La tension du générateur 3 est ajustée de façon à compenser exactement la tension à vide de la pile 1 pour éviter qu'elle ne débite un courant continu. L'entrée 10c du pont 10 est reliée à la sortie 14c de l'unité de commande 14 et l'entrée 10d de ce pont est connectée à la sortie 11b de l'oscillateur 11. Les sorties 10e et 10f du pont 10 sont reliées respectivement aux entrées 12a et 12b de l'unité de calcul 12 dont l'entrée 12c est connectée à la sortie 14e de l'unité de commande 14. La sortie 12d de l'unité de calcul est reliée à l'entrée de l'affichage 13, pour indiquer a12 ou directement D après étalonnage de l'appareil. Enfin l'entrée 11a de l'oscillateur 11 est reliée à la sortie 14d de l'unité de commande 14 dont les entrées 14a et 14b sont connectées aux deux bornes d'un contact actionné par le bouton 15. La source d'énergie alimentant les divers circuits de l'appareil n'a pas été représentée.

Le fonctionnement de l'appareil représenté sur la figure 4 est le suivant. Après la mise en place de la pile à tester 1, une pression sur le bouton 15 a pour effet de déclencher la séquence de mesure qui comprend plusieurs phases. Les différentes phases de mesure sont contrôlées par l'unité de commande 14 qui envoie, dans un ordre défini par un programme, des signaux de commande au pont 10, à l'oscillateur 11 et à l'unité de calcul 12. La première phase comprend la commande de l'oscillateur 11 pour qu'il fournisse à sa sortie la fréquence de mesure f1, la commande du pont 10 pour qu'il effectue la mesure de Z1 et pour qu'il fasse apparaître sur sa sortie 10e la valeur de R1 et sur sa sortie 10f la valeur de X1, enfin la commande de l'unité de calcul 12 pour qu'elle mémorise les valeurs de R1 et de X1. La seconde phase est similaire à la première sauf que la commande de l'oscillateur fait apparaître à sa sortie la fréquence de mesure f2 et que finalement l'unité de calcul 12 mémorise les valeurs de R2 et de X2. Enfin la troisième phase comprend la commande de l'unité de calcul 12 pour que cette unité calcule, à partir des valeurs mémorisées de R1, R2, X1 et X2, la valeur de l'argument a12 = arc tg (X1-X2)/(R1-R2) et pour qu'elle indique cette valeur sur l'affichage 13. L'unité de calcul 12 peut contenir en mémoire des tableaux de correspondance entre a12 et D, chaque tableau correspondant à un type de pile donné, permettent de faire apparaître sur l'affichage 13 directement la valeur de l'état de décharge D de la pile.

Avantageusement le pont de mesure 10 peut être le Frequency Response Analyser 1174 de Solartron, dans lequel est incorporé l'oscillateur 11, et le générateur de tension continue 3 peut être l'Electrochemical Interface 1186 du même constructeur. Enfin il y a intérêt à utiliser pour l'unité de calcul 12, l'affichage 13 et l'unité de commande 14 un mini-ordinateur, par exemple le Desktop Computer 9825 de Hewlett Packard, qui rassemble toutes les fonctions nécessaires.

**Revendications**

1. Procédé de mesure de l'état de décharge (D) d'une pile (1) présentant une impédance interne (Z), caractérisé en ce qu'il consiste :
à mesurer une première impédance interne (Z1) de la pile (1) à une première fréquence (f1) ;
à mesurer une seconde impédance interne (Z2) de la pile (1) à une seconde fréquence (f2) ;
à déterminer la différence (Z12) entre lesdites impédances internes (Z1, Z2) ; et
à déterminer l'argument (a12) de ladite différence (Z12), ledit argument (a12) étant représentatif de l'état de décharge (D) de la pile (1).

2. Procédé de mesure selon la revendication 1, caractérisé en ce que la plus basse desdites fréquences (f1, f2) est comprise entre 0.1 et 10 Hz.

3. Procédé de mesure selon la revendication 1, caractérisé en ce que la plus élevée desdites fréquences (f1, f2) est telle que la partie réactive (X) de ladite impédance interne (Z) est sensiblement nulle à cette fréquence.

4. Procédé de mesure selon la revendication 1, caractérisé en ce que la plus haute desdites fréquences (f1, f2) est de l'ordre de 10 kHz.

5. Appareil de mesure pour la détermination de l'état de décharge (D) d'une pile (1) comprenant des moyens (3) empêchant la pile (1) de débiter un courant continu et des moyens (10, 11, 14) permettant de mesurer une première impédance interne (Z1) de la pile (1) à une première fréquence (f1) et une seconde impédance interne (Z2) de la pile (1) à une seconde fréquence (f2), caractérisé en ce qu'il comporte, en outre, des moyens (12, 14) permettant de déterminer la différence (Z12) desdites impédances internes (Z1, Z2) et l'argument (a12) de ladite différence (Z12), et des moyens (13) permettant d'afficher la valeur dudit argument (a12), représentatif de l'état de décharge (D) de la pile (1).

**Claims**

1. A method of measuring the state of discharge (D) of a battery (1) having an internal impedance, characterized in that it comprises :
measuring a first internal impedance (Z1) of the battery (1) at a first frequency (f1) ;

measuring a second internal impedance (Z2) of the battery (1) at a second frequency (f2) ;

determining the difference (Z12) between said internal impedances (Z1, Z2) ; and

determining the argument (a12) of said difference (Z12), said argument (a12) being representative of the state of discharge (D) of the cell (1).

2. A method of measuring according to claim 1, characterized in that the lower of said frequencies (f1, f2) lies between 0.1 and 10Hz.

3. A method of measuring according to claim 1, characterized in that the higher of said frequencies (f1, f2) is such that the reactive part (X) of said internal impedance (Z) is substantially nil at this frequency.

4. A method of measuring according to claim 1, characterized in that the higher of said frequencies (f1, f2) is in the region of 10kHz.

5. A measurement apparatus for ascertaining the state of discharge (D) of a battery (1), comprising means (3) for preventing the battery (1) from issuing a direct current and means (10, 11, 14) for enabling a first internal impedance (Z1) of the battery (1) to be measured at a first frequency (f1) and a second internal impedance (Z2) of the battery (1) to be measured at a second frequency (f2), characterized in that it further comprises means (12, 14) for enabling the difference (Z12) between said internal impedances (Z1, Z2) and the argument (a12) of said difference (Z12) to be determined, and means (13) for enabling the value of said argument (a12), which is representative of the state of discharge (D) of the battery (1), to be displayed.

## Patentansprüche

1. Verfahren zum Messen des Entladezustandes (D) einer Batterie (1) mit einer internen Impedanz (Z), dadurch gekennzeichnet, daß es besteht aus :

einer Messung einer ersten internen Impedanz (Z1) der Batterie (1) bei einer ersten Frequenz (f1) einer Messung einer zweiten internen Impedanz (Z2) der Batterie (1) bei einer zweiten Frequenz (f2)

einer Bestimmung der Differenz (Z12) zwischen den genannten internen Impedanzen (Z1, Z2) und

einer Bestimmung des Arguments (a12) der genannten Differenz (Z12), welches genannte Argument (a12) repräsentativ ist für den Entladezustand (D) der Batterie (1).

2. Verfahren zum Messen nach Anspruch 1, dadurch gekennzeichnet, daß die niedrigere der genannten Frequenzen (f1, f2) zwischen 0,1 und 10 Hz liegt.

3. Verfahren zum Messen nach Anspruch 1, dadurch gekennzeichnet, daß die höhere der genannten Frequenzen (f1, f2) derart ist, daß der reaktive Anteil (X) der genannten internen Impedanz (Z) im wesentlichen bei dieser Freuquenz Null ist.

4. Verfahren zum Messen nach Anspruch 1, dadurch gekennzeichnet, daß die höhere der genannten Frequenzen (f1, f2) in der Größenordnung von 10 KHz ist.

5. Messvorrichtung für die Bestimmung des Entladezustandes (D) einer Batterie (1), umfassend Mittel (3) zum Verhindern der Abgabe eines Gleichstromes durch die Batterie (1) und Mittel (10, 11, 14), die die Messung einer ersten internen Impedanz (Z1) der Batterie (1) bei einer ersten Frequenz (f1) und einer zweiten internen Impedanz (Z2) der Batterie (1) bei einer zweiten Frequenz (f2) ermöglichen, dadurch gekennzeichnet, daß sie zusätzlich Mittel (12, 14) umfaßt, die die Bestimmung der Differenz (Z12) der genannten internen Impedanzen (Z1, Z2) ermöglichen sowie des Arguments (a12) der genannten Differenz (Z12),sowie Mittel (13), die es ermöglichen, den für den Entladezustand (D) der Batterie (1) repräsentativen Wert des genannten Arguments (a12) anzuzeigen.

Fig.1

Fig.2

Fig.2a

Fig. 3

Fig. 4